# EUROPEAN PATENT APPLICATION

(11) **EP 4 641 644 A1**
(43) Date of publication of application: **29.10.2025**
(21) Application number: 24305639.7
(22) Date of filing: 25.04.2024
(51) Int. Cl.: H01L 31/18, H01L 21/02, H01L 31/0304, H01L 31/0352

(54) **LAYERED SEMICONDUCTOR STRUCTURE AND METHOD OF FABRICATING LAYERED SEMICONDUCTOR STRUCTURE**

(71) Applicant: Nokia Technologies Oy, 02610 Espoo (FI)
(72) Inventor: BESANCON, Claire, 75014 Paris (FR); DECOBERT, Jean, 91620 Nozay (FR)
(74) Representative: Novagraaf Technologies

(57) **Abstract**

There is provided a layered semiconductor structure 100 and a method of fabricating a layered semiconductor structure. The layered semiconductor structure comprises a silicon substrate (101), a silica layer on the silicon substrate (102), an InP-based layer on the silica layer (103), and an InXP layer (104) on the InP-based layer, wherein X is one of Al or Ga, or a combination of Al and Ga.

## Description

### Field

Examples of the present disclosure relate to layered semiconductor structures and layered semiconductor structure fabrication methods.

### Background

InP on silicon (InPoSi) semiconductor technology utilises InP on a silicon substrate to allow for the integration of InP-based devices on the silicon platform. However, there are challenges combining such technologies in order to exploit the beneficial characteristics of both InP and the silicon substrate.

An objective of the present disclosure is to address such challenges, amongst others.

### Summary

In a first exemplary aspect, there is provided a layered semiconductor structure, comprising a silicon substrate, a silica layer on the silicon substrate, an InP-based layer on the silica layer, and an InXP layer on the InP-based layer, wherein X is one of Al or Ga, or a combination of Al and Ga.

Optionally, an In : X ratio in the InXP layer is in a range of 0.999 : 0.001 to 0.95 : 0.05.

Optionally, an In : X ratio in the InXP layer is 0.99 : 0.01.

Optionally, the InXP layer has a thickness in a range between 5 nm and 10 µm.

Optionally, the InP-based layer is an InP layer.

Optionally, the InP-based layer is a second InXP layer, wherein in the second InXP layer X is one of Al or Ga, or a combination of Al and Ga.

In a second exemplary aspect, there is provided a photonic structure comprising a least one layered semiconductor structure according to the first exemplary aspect.

Optionally, the photonic structure comprises a quantum well layer on the InXP layer, and a third InXP layer on the quantum well layer, wherein in the third InXP layer X is one of Al or Ga, or a combination of Al and Ga.

Optionally, one or more silicon photonic components are arranged in the silica layer.

In a third exemplary aspect, there is provided a photodiode structure comprising at least one layered semiconductor structure according to the first exemplary aspect.

Optionally, the photodiode structure comprises a first InGaAs layer on the InXP layer, a fourth InXP layer on the first InGaAs layer, wherein in the fourth InXP layer X is one of Al or Ga, or a combination of Al and Ga, and a second InGaAs layer on the fourth InXP layer.

In a fourth exemplary aspect, there is provided a high electron mobility transistor, HEMT, structure comprising at least one layered semiconductor structure according to the first aspect.

Optionally, the HEMT structure comprises an InGaAs collector layer on the InXP layer, an InGaAs base layer on the InGaAs collector layer, an InXP emitter layer on the InGaAs base layer, wherein in the InXP emitter layer X is one of Al or Ga, or a combination of Al and Ga, and an InGaAs cap layer on the InXP emitter layer.

In a fifth exemplary aspect, there is provided a method of fabricating a layered semiconductor structure, the method comprising providing a silicon substrate with a silica layer on the silicon substrate, arranging an InP-based layer on the silica layer, and depositing an InXP layer on the InP-based layer, wherein X is one of Al or Ga, or a combination of Al and Ga.

Optionally, the method further comprises:
depositing a quantum well layer on the InXP layer, and depositing a third InXP layer on the quantum well layer, wherein in the third InXP layer X is one of Al or Ga, or a combination of Al and Ga; or
depositing a first InGaAs layer on the InXP layer, depositing a fourth InXP layer on the first InGaAs layer, and depositing a second InGaAs layer on the fourth InXP layer, wherein in the fourth InXP layer X is one of Al or Ga, or a combination of Al and Ga; or
depositing an InGaAs collector layer on the InXP layer, depositing an InGaAs base layer on the InGaAs collector layer, depositing an InXP emitter layer on the InGaAs base layer, and depositing an InGaAs cap layer on the InXP emitter layer, wherein in the InXP emitter layer X is one of Al or Ga, or a combination of Al and Ga.

### Brief Description of the Drawings

Examples of the disclosure are now described, with reference to the drawings, in which:
FIG. 1 is a schematic cross-sectional diagram of a first layered semiconductor structure;
FIG. 2 is a flow chart of a method of fabricating the first layered semiconductor structure;
FIG. 3A is a schematic cross-sectional diagram of a second layered semiconductor structure;
FIG. 3B is a schematic cross-sectional diagram of a third layered semiconductor structure;
FIG. 4 is a flow chart of a method of fabricating the second layered semiconductor structure and the third layered semiconductor structure;
FIG. 5 is a schematic cross-sectional diagram of a fourth layered semiconductor structure;
FIG. 6 is a flow chart of a method of fabricating the fourth layered semiconductor structure;
FIG. 7 is a schematic cross-sectional diagram of a fifth layered semiconductor structure; and
FIG. 8 is a flow chart of a method of fabricating the fifth layered semiconductor structure.

### Detailed Description

InP can be arranged on a silicon substrate to fabricate an InPoSi wafer. Further layers (for example, III-V layers, and others) can then be grown into/onto the InP layer to form device structures. Typically, hydrophilic direct bonding is used to bond the InP to the silicon substrate for an InPoSi wafer. However, because InP has a lower thermal coefficient than silicon, the InP layer of InPoSi wafer is compressively strained at elevated temperatures (e.g., epitaxial growth temperatures). The wafer can be subjected to these elevated temperatures, for example, during III-V material growth.

This compressive strain leads to undulations and even degradation of the III-V grown material on the InPoSi wafer due to the InP and silicon being linked by hydrophilic bonds. This can negatively impact the electronic and optoelectronic properties, particularly as the III-V stack increases in thickness, thereby having a detrimental effect on device performance.

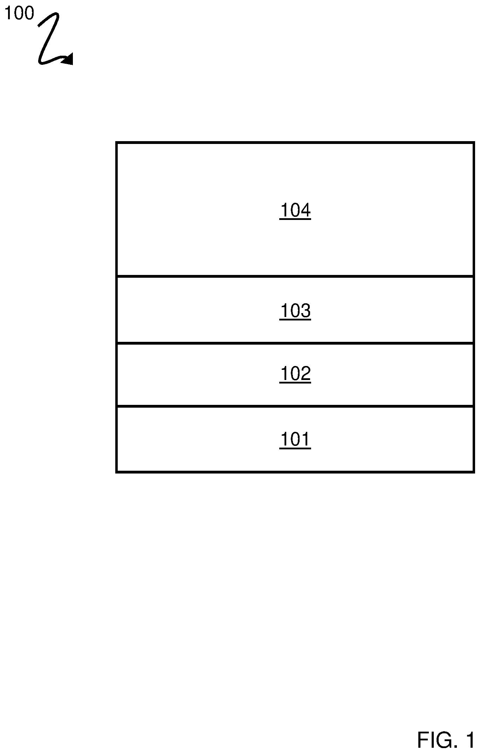

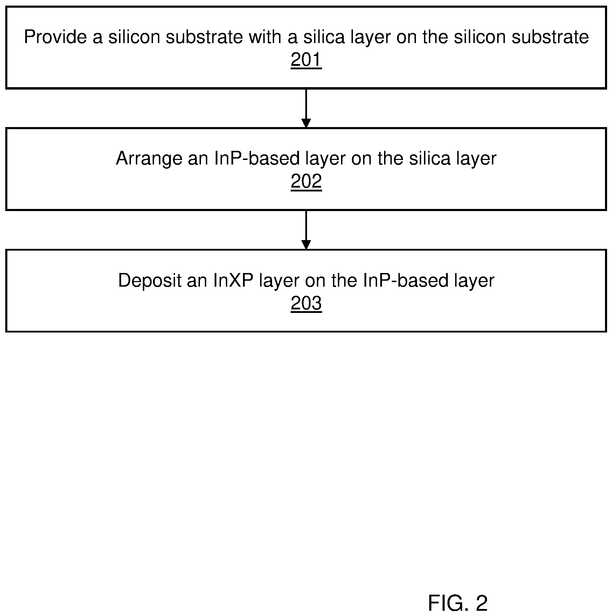

The present disclosure provides a layered semiconductor structure, and method of fabrication thereof, described respectively with regard to FIGS. 1 and 2, that can obviate such issues.

FIG. 1 is a schematic cross-sectional diagram of a first layered semiconductor structure 100. The layered semiconductor structure comprises a silicon substrate 101, this can be for example a silicon wafer, such as a 300 mm silicon wafer. A silica layer 102 is arranged on the silicon substrate 101.

An InP-based layer 103 is arranged on the silica layer 102, and the resulting arrangement can be considered an InPoSi wafer. The InP-based layer 103 can be considered as a template layer used for regrowth.

Then, an InXP layer 104 is arranged on the InP-based layer 103. In the InXP layer 104, X is one or Al or Ga, or a combination of Al and Ga. That is, the InXP layer 104 can be InAIP, InGaP, or InAlGaP. The InXP layer 104 can be arranged directly on the InP-based layer 103 (i.e., with no further layers separating the InXP layer 104 and the InP-based layer 103).

In the InXP layer 104, an In : X ratio in the InXP layer can be in a range of 0.999 : 0.001 to 0.95 : 0.05. That is, the contribution of X as an atomic percentage of the total In and X can be in the range of 0.1 to 5 at.%. In other words, the contribution of X (Al, Ga, or Al + Ga) in the total cation part (i.e., In and X) of the InXP compound can be in the range of 0.1 to 5 at.% (i.e., In_{0.999}X_{0.001} P to In_{0.95}X_{0.05}P).

In the example of InAIP, the Al can be in the range of 0.1 to 5 at.% of the combined In and Al. In the example of InGaP, the Ga can be in the range of 0.1 to 5 at.% of the combined In and Ga. In the example of InAIGaP, the combined Al and Ga can be in the range of 0.1 to 5 at.% of the combined In, Al and Ga.

In a more specific example, an In : X ratio in the InXP layer can be 0.99 : 0.01. That is, the contribution of X as an atomic percentage of the total In and X can be 1 at.% (i.e., In_{0.99}X_{0.01}P). In other words, the contribution of X (Al, Ga, or Al + Ga) in the total cation part (i.e., In and X) of the InXP compound can be 1 at.% (i.e., In_{0.99}X_{0.01}P). In such examples, when X = Al, the InXP layer can be In_{0.99}Al_{0.01}P; in other words, in this specific example, the Al is 1 at.% of the In and Al. When X = Ga, the InXP layer can be In_{0.99}Ga_{0.01}P; in other words, in this specific example, the Ga is 1 at.% of the In and Ga. When X = Al + Ga, the InXP layer can be for example In_{0.99}Al_{0.005}Ga_{0.005}P, with Al being 0.5 at.% of the combined Al, Ga and In, and Ga being 0.5 at.% of the combined Al, Ga and In. The skilled person will realise however that when X = Al + Ga, there need not be equal amounts of Al and Ga; for example, it could be In_{0.99}Al_{0.002}Ga_{0.008}P, amongst other examples.

The InXP layer can have a thickness that is greater than or equal to 5 nm. The InXP layer can also have a thickness that is less than or equal to 10 µm. More specifically, the InXP layer can have a thickness in the range of 5 nm to 10 µm.

In some examples, the InP-based layer 103 can be InP.

In other examples, the InXP layer 104 can be considered as a first InXP layer 104, and the InP-based layer 103 can be a second InXP layer 103. In other words, the InP-based layer 103 can itself also be InXP, wherein X is Al, or Ga, or a combination of Al and Ga. In such an example, this second InXP layer 103 is arranged between the first InXP layer 104 and the silica layer 102. The second InXP layer 103 can be substantially similar to the aforementioned first InXP layer 104, as described above, and therefore the detail is not repeated for brevity. In some examples, the first InXP layer 104 and the second InXP layer 103 can be the same layer; that is, there can be a single layer of InXP on the silica layer 102.

FIG. 2 is a flow chart of a method of fabricating the first layered semiconductor structure 100 of FIG. 1.

At step 201, the silicon substrate 101 with the silica layer 102 thereon is provided.

At step 202, the InP-based layer 103 is arranged on the silica layer 103. For example, wafer bonding is used to arrange the InP-based layer 103 onto silica layer 102 on the silicon substrate. This can involve a hydrophilic direct bonding process. A smart-cut process, for example, or a sacrificial layer can be used to remove the InP substrate. This step can be performed at room temperature, before heating to approximately 300°C.

At step 203, the InXP layer 104 is deposited on the InP-based layer 103. For example, the InXP layer can be epitaxially grown on the InP-based layer, and this can take place at approximately 500°C or above.

Advantageously, the approach described with reference to FIGS. 1 and 2 compensates the compressive thermal strain induced at growth temperature between the InP and silicon substrate through the inclusion of the InXP layer which introduces a tensile strain. This compensates the compressive thermal strain on InPoSi at growth temperature. This mitigates the adverse effects induced by the by the compressive thermal strain. Therefore, III-V devices of improved quality can be provided on the InPoSi through improved substrate properties.

As discussed, the tensile strain on the InP layer at growth temperature can be obtained by adding a small amount of X to InP to provide an InXP layer, wherein X = Al, Ga or Al + Ga. The properties of such an alloy are similar to those of the InP material due to the small amount of Al and/or Ga used. As such, the inclusion of X (Al, Ga or Al + Ga) does not adversely affect the suitability of the InPoSi substrate for the integration of III-V devices.

For semiconductor stacks that also include InGaAs layers, when using Ga or Al + Ga as X in the InXP layer, the Ga/In ratio can be enhanced as compared to standard ratio used.

The compensation brought about by the tensile strain provided by the InXP is particularly beneficial for implementation with thicker layers of a III-V stack (e.g., greater than 200 nm) as these are more susceptible to undulations and decreased material quality due to the compressive strain at growth temperatures from the lower thermal coefficient of Si as opposed to that of InP..

InP-based structures often use an InP material for cladding layers, and these are typically greater 500 nm in thickness. Using a small ratio of X (wherein X = Al and/or Ga) to form the InXP alloy (for example with the ratio In_{0.99}X_{0.01}P) forms a tensively strained structure on the InP at growth temperature. On InPoSi, this structure compensates the intrinsic compressive strain induced in the InP layer from InPoSi. Such an arrangement has been found to mitigate any effects of undulation and decreased material quality due to the compressive thermal strain.

It has also been found that for a multiple quantum well (MQW) based structure grown on top of an InXP layer on InPoSi, a superior material quality is achieved for the structure grown using the strain compensation induced by the InXP layer when compared to only an InP layer.

Likewise, for periodic InP/InAsP grown on InPoSi with an InXP layer for stain compensation has been found to provide a superior crystal quality of the structure when compared to only an InP layer.

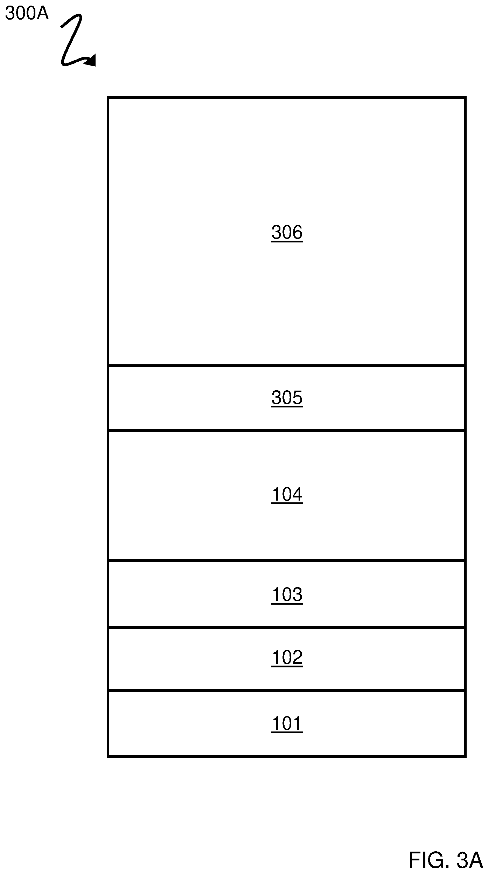

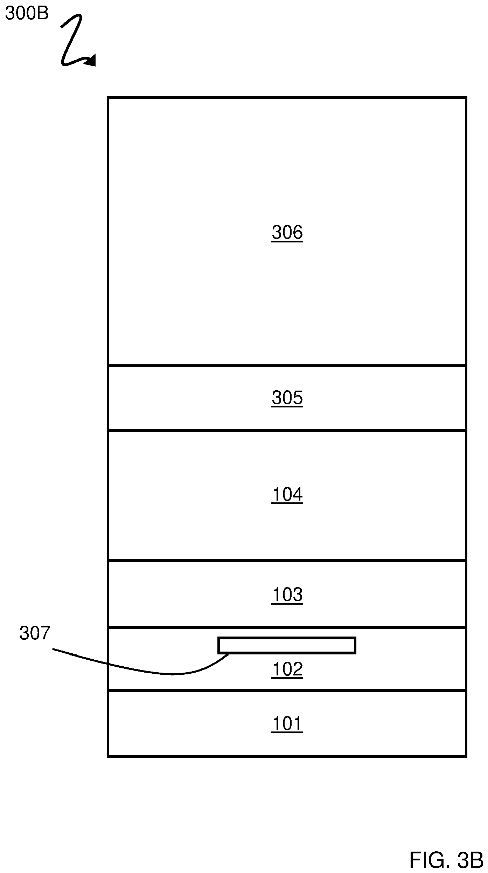

The principles of FIGS. 1 and 2 can be applied to further structures using the layered structure of FIG. 1, fabricated by the process of FIG. 2, as a base. These are described with reference to FIGS. 3 to 8, as follows.

FIG. 3A is a schematic cross-sectional diagram of a second layered semiconductor structure 300A. The second layered semiconductor structure 300A can be considered a photonic structure, and can comprise at least one layered semiconductor structure 100 as described with reference to FIG 1.

In more detail, the second layered semiconductor structure 300a comprises the silicon substrate 101, silica layer 102, InP-based layer 103, and InXP layer 104 as described with reference to FIG. 1, and for brevity the details of which are not repeated here.

The photonic structure 300A can comprise a quantum well layer 305 on the InXP layer 104. The quantum well layer 305 can comprise single quantum wells or multiple quantum wells formed as layers. For example, the quantum well layer 305 can comprise AlGaInAs/InGaAsP.

An additional InXP layer 306 (which can be referred to as a third InXP layer) is arranged on the quantum well layer. In this additional InXP layer 306, X can be one of Al or Ga, or a combination of Al and Ga, as in the InXP layer 104. In a specific example, both the InXP layer 104 and the additional InXP layer 306 can be InGaP. This additional InXP layer 306 can also provide compensation for the compressive thermal strain.

In the photonic structure 300A, the InXP layer 104, the quantum well layer 305, and the additional InXP layer 306, can have a combined thickness that is greater than 1 µm.

FIG. 3B shows a schematic cross-sectional diagram of a third layered semiconductor structure 300B. The third layered semiconductor structure 300B can be considered a photonic structure, and can comprise at least one layered semiconductor structure as described with reference to FIG 1. The third layered semiconductor structure 300B can be substantially the same as the second layered semiconductor structure 300A. The difference between the third layered semiconductor structure 300B and the second layered semiconductor structure 300A being that the third layered semiconductor structure 300B is a photonic structure with one or more silicon photonic components 307 embedded in the silica layer 102. In some examples, the one or more silicon photonic components 307 can comprise one or more passive waveguides and/or gratings.

The photonic structures of the second layered semiconductor structure 300A and the third layered semiconductor structure 300B can be optical amplifiers used for a laser. The third semiconductor structure 300B can use optical interaction with a silicon waveguide buried in the oxide to allow for the use of Si-photonics circuitry.

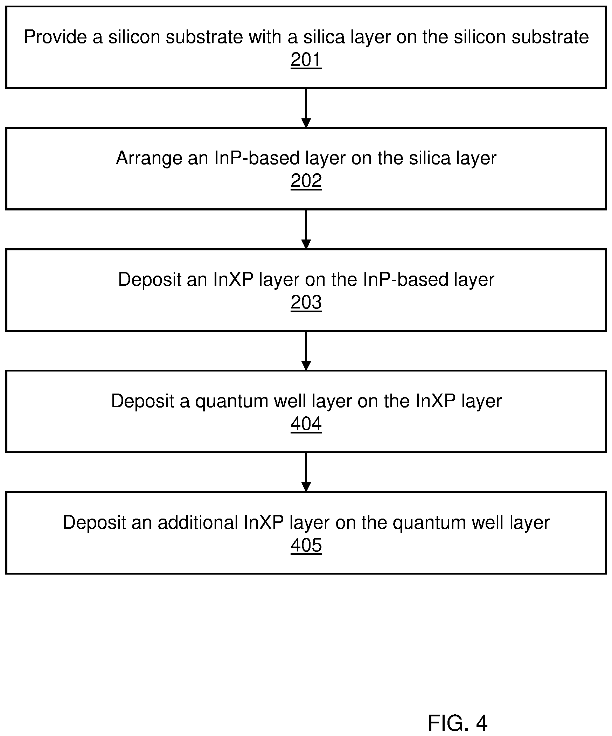

FIG. 4 is a flow chart of a method of fabricating the second layered semiconductor structure 300A of FIG. 3A and the third layered semiconductor structure 300B of FIG. 3B.

The process includes steps 201, 202 and 203, of FIG. 2, and these directly correspond to those described with reference to FIG. 2 so the detail is not repeated here for brevity.

At step 404, following step 203, the quantum well layer 305 is deposited on the InXP layer 104.

Then, at step 405, the additional InXP layer 306 (also referred to as the third InXP layer) is deposited on the quantum well layer 305.

In the case of the third layered semiconductor structure 300B (FIG. 3B), the one or more silicon photonic components 307 can be embedded into the silica layer 102 before the InP-based layer 103 is arranged thereon.

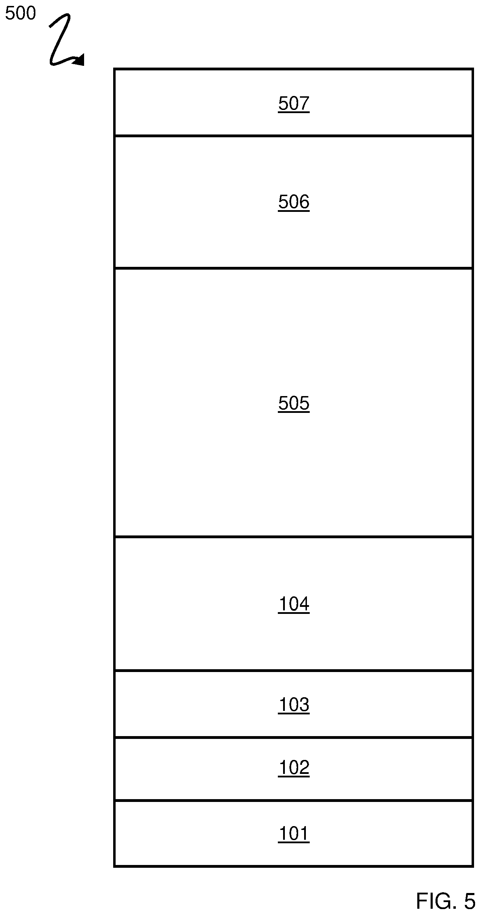

FIG. 5 is a schematic cross-sectional diagram of a fourth layered semiconductor structure 500. The fourth layered semiconductor structure 500 can be considered a photodiode structure, and can comprise at least one layered semiconductor structure 100 as described with reference to FIG 1.

In more detail, the photodiode structure 500 can be an InGaAs-based photodiode structure, and can be arranged as follows.

The fourth layered semiconductor structure 500 comprises the silicon substrate 101, silica layer 102, InP-based layer 103, and InXP layer 104 as described with reference to FIG. 1, and for brevity the details of which are not repeated here.

The photodiode structure 500 can comprise a first InGaAs layer 505 on the InXP layer 104. An additional InXP layer 506 (which can be referred to as a fourth InXP layer) can be arranged on the first InGaAs layer 505. In this additional InXP layer, X can be one of Al or Ga, or a combination of Al and Ga, as in the InXP layer 104. In a specific example, both the InXP layer 104 and the additional InXP layer 506 can be InGaP. This additional InXP layer 506 can also provide compensation for the compressive thermal strain.

A second InGaAs layer 507 can be arranged on the additional InXP layer 506.

In a specific example of the photodiode structure, the InXP layer 104 and additional InXP layer 506 can both be InGaP.

The InXP layer 104, the first InGaAs layer 505, the additional InXP layer 506, and the second InGaAs layer 507, can be have a combined thickness that is greater than 1 µm.

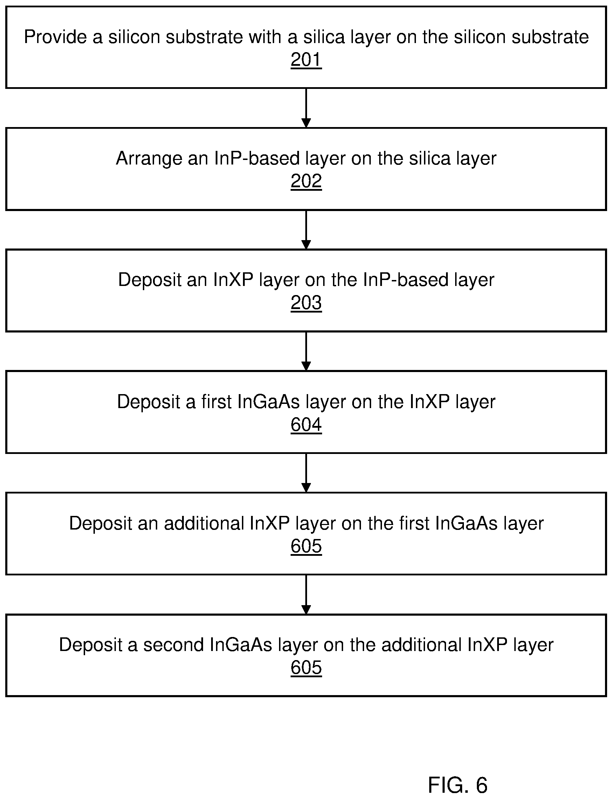

FIG. 6 is a flow chart of a method of fabricating the fourth layered semiconductor structure 500 of FIG. 5.

The process includes steps 201, 202 and 203, of FIG. 2, and these directly correspond to those described with reference to FIG. 2 so the detail is not repeated here for brevity.

At step 604, following step 203, the first InGaAs 505 layer can be deposited on the InXP layer 104.

Then, at step 605, the additional InXP layer 506 (also referred to as a fourth InXP layer) can be deposited on the first InGaAs layer 505.

The second InGaAs layer 507 can then be deposited on the additional InXP layer 506 at step 605.

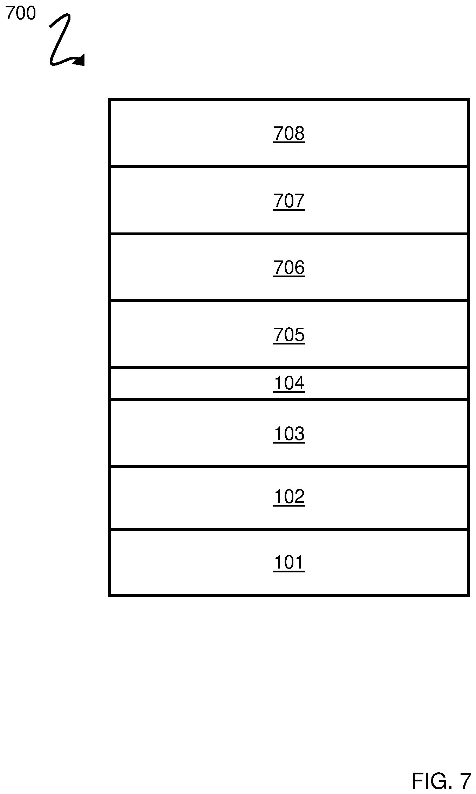

FIG. 7 is a schematic cross-sectional diagram of a fifth layered semiconductor structure 700. The fifth layered semiconductor structure 700 can be considered a high electronic mobility (HEMT) structure, and can comprise at least one layered semiconductor structure 100 as described with reference to FIG 1.

In more detail, the fifth layered semiconductor structure 700 comprises the silicon substrate 101, silica layer 102, InP-based layer 103, and InXP layer 104 as described with reference to FIG. 1, and for brevity the details of which are not repeated here.

An InGaAs collector layer 705 can be arranged on the InXP layer 104. An InGaAs base layer 706 can be arranged on the InGaAs collector layer 705. An InXP emitter layer 706 can be arranged on the InGaAs base layer 705. In the InXP emitter layer 706, X can be Al, or, or a combination of Al and Ga, in a similar manner to that already described for the InXP layer 104 (the detail is not repeated here, for brevity). This InXP emitter layer 706 can also provide compensation for the compressive thermal strain. An InGaAs cap layer 707 can be arranged on the InXP emitter layer 706.

In a specific example of the HEMT structure 700, the InXP layer 104 can be InGaP, and the InXP emitter layer 706 can be InGaP.

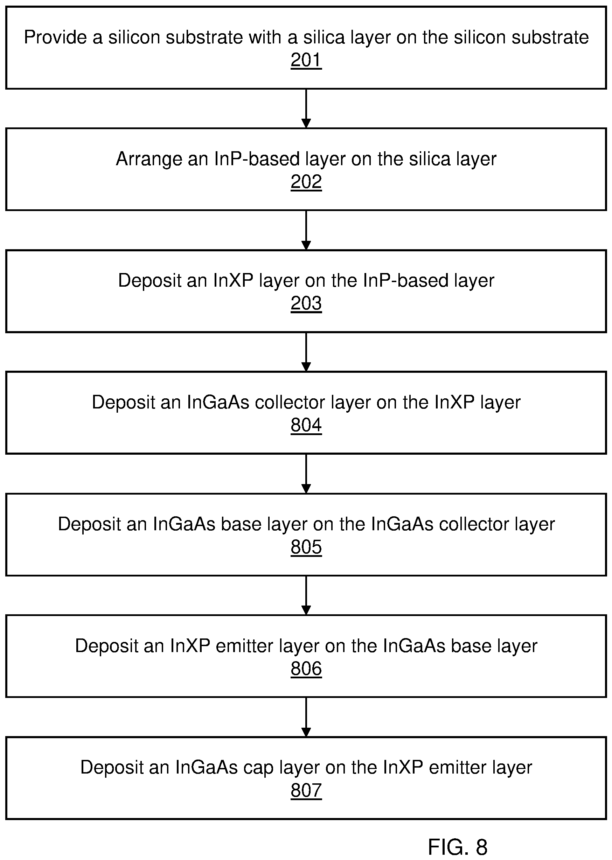

FIG. 8 is a flow chart of a method of fabricating the fifth layered semiconductor structure 700 of FIG. 7.

The process includes steps 201, 202 and 203, of FIG. 2, and these directly correspond to those described with reference to FIG. 2 so the detail is not repeated here for brevity.

At step 804, after step 203, the InGaAs collector layer 705 can be deposited on the InXP layer 104.

At step 805, the InGaAs base layer 706 can be deposited on the InGaAs collector layer 705.

At step 806, the InXP emitter layer 706 can be deposited on the InGaAs base layer 705.

At step 807, the InGaAs cap layer 707 can be deposited on the InXP emitter layer 706.

Although the foregoing description has been set out with reference to particular examples, it is to be understood that these examples are merely illustrative of the principles and applications of the present disclosure. It is therefore to be understood that numerous modifications can be made to the illustrative examples and that other arrangements can be devised without departing from the spirit and scope of the disclosure as determined based upon the claims and any equivalents thereof.

## Claims

1. A layered semiconductor structure (100), comprising:
a silicon substrate (101);
a silica layer (102) on the silicon substrate;
an InP-based layer (103) on the silica layer; and
an InXP layer (104) on the InP-based layer, wherein X is one of Al or Ga, or a combination of Al and Ga.

2. The layered semiconductor structure of claim 1, wherein an In : X ratio in the InXP layer is in a range of 0.999 : 0.001 to 0.95 : 0.05.

3. The layered semiconductor structure of claim 1, wherein an In : X ratio in the InXP layer is 0.99: 0.01.

4. The layered semiconductor structure of any preceding claim, wherein the InXP layer has a thickness in a range between 5 nm and 10 µm.

5. The layered semiconductor structure of any preceding claim, wherein the InP-based layer is an InP layer.

6. The layered semiconductor structure of any one of claims 1 to 4, wherein the InP-based layer is a second InXP layer, wherein in the second InXP layer X is one of Al or Ga, or a combination of Al and Ga.

7. A photonic structure (300A, 300B) comprising a least one layered semiconductor structure according to any preceding claim.

8. The photonic structure of claim 7, wherein the photonic structure comprises a quantum well layer (305) on the InXP layer, and a third InXP layer (306) on the quantum well layer, wherein in the third InXP layer X is one of Al or Ga, or a combination of Al and Ga.

9. The photonic structure of claim 8, wherein one or more silicon photonic components (307) are arranged in the silica layer.

10. A photodiode structure (500) comprising at least one layered semiconductor structure according to any one of claims 1 to 6.

11. The photodiode structure of claim 10, wherein the photodiode structure comprises a first InGaAs layer (505) on the InXP layer, a fourth InXP layer (506) on the first InGaAs layer, wherein in the fourth InXP layer X is one of Al or Ga, or a combination of Al and Ga, and a second InGaAs layer (507) on the fourth InXP layer.

12. A high electron mobility transistor, HEMT, structure (700) comprising at least one layered semiconductor structure according to any one of claims 1 to 6.

13. The HEMT structure of claim 12, wherein the HEMT structure comprises an InGaAs collector layer (705) on the InXP layer, an InGaAs base layer (706) on the InGaAs collector layer, an InXP emitter layer (707) on the InGaAs base layer, wherein in the InXP emitter layer X is one of Al or Ga, or a combination of Al and Ga, and an InGaAs cap layer (708) on the InXP emitter layer.

14. A method of fabricating a layered semiconductor structure, the method comprising:
providing (201) a silicon substrate with a silica layer on the silicon substrate;
arranging (202) an InP-based layer on the silica layer; and
depositing (203) an InXP layer on the InP-based layer, wherein X is one of Al or Ga, or a combination of Al and Ga.

15. The method of claim 14, wherein the method further comprises:
depositing (404) a quantum well layer on the InXP layer, and depositing (405) a third InXP layer on the quantum well layer, wherein in the third InXP layer X is one of Al or Ga, or a combination of Al and Ga; or
depositing (604) a first InGaAs layer on the InXP layer, depositing (605) a fourth InXP layer on the first InGaAs layer, and depositing (606) a second InGaAs layer on the fourth InXP layer, wherein in the fourth InXP layer X is one of Al or Ga, or a combination of Al and Ga; or
depositing (804) an InGaAs collector layer on the InXP layer, depositing (805) an InGaAs base layer on the InGaAs collector layer, depositing (806) an InXP emitter layer on the InGaAs base layer, and depositing (807) an InGaAs cap layer on the InXP emitter layer, wherein in the InXP emitter layer X is one of Al or Ga, or a combination of Al and Ga.
